# FASCICULE DE BREVET EUROPEEN

(11) **EP 3 987 431 B1**
(45) Date de publication et mention de la délivrance du brevet: **28.05.2025**
(21) Numéro de dépôt: 20732991.3
(22) Date de dépôt: 19.06.2020
(51) Int. Cl.: G06K 7/00, H05K 1/02

(54) **SYSTÈME DE LECTURE DE CARTE DE TRANSACTION HYBRIDE**
HYBRIDES TRANSAKTIONSKARTENLESESYSTEM
HYBRID TRANSACTION CARD READING SYSTEM

(30) Priorité: 20.06.2019 FR 1906684
(43) Date de publication de la demande: 27.04.2022
(73) Titulaire: Banks and Acquirers International Holding, 75015 Paris (FR)
(72) Inventeur: PANETTA, Florence, 26450 La Chapelle-en-Vercors (FR); FABREGOULE, Olivier, 07500 Guilherand Granges (FR); DEVORNIQUE, Roger, 26000 Valence (FR); MOREL, Pierre, 26300 Charpey (FR); ALLIROT, Richard, 38700 Corenc (FR)
(74) Mandataire: Germain Maureau
(86) Numéro de dépôt international: PCT/EP2020/067235
(87) Numéro de publication internationale: WO 2020/254651

(56) Documents cités:
- EP-A1- 1 432 031
- FR-A1- 2 889 756
- US-A1- 2010 327 856

## Description

### 1. Domaine technique

La demande de brevet se rapporte à un lecteur hybride de cartes de transaction. L'invention se rapporte plus particulièrement à un lecteur hybride qui offre une sécurité importante tout en assurant un niveau de compacité compatible avec les contraintes liées à ce type de dispositif.

### 2. Art Antérieur

Les dispositifs et procédés de la présente invention décrits ici sont utiles pour utiliser une carte désignée par le terme carte de transaction, qui comprend une ou plusieurs technologies de communication.

Généralement, la carte de transaction a au moins une bande magnétique sur sa surface qui peut être glissée sur un terminal de point de vente pour compléter une transaction en vue du paiement d'un bien ou d'un service. La norme ISO/CEE 7810 qui définit les dimensions d'une carte de transaction, généralement à 85,60 x 53,98 millimètres. Toutes les cartes de transaction normalisées ont généralement une épaisseur de 0,76 pour une carte.

Une carte de transaction peut également prendre la forme d'une carte à puce ou carte à circuit intégré, car elle peut comprendre une puce (chip). Une carte à puce est bien connue dans la technique et possède un circuit intégré capable de traiter des informations. Une carte à puce peut recevoir une entrée qui est traitée via le circuit intégré ou la puce avec une application basée sur celle-ci, puis fournir une sortie. Une carte à puce à contact a une zone de contact composée de plusieurs plages de contact. Lorsque la carte à puce de contact est insérée dans un lecteur qui entre en contact avec des connecteurs électriques capables de lire des informations sur la puce et de les écrire en retour. Une carte à puce typique suit les dimensions de l'ISO/IEC 7810 qui détermine les dimensions de la carte et de l'ISO / IEC 7816 qui définit l'emplacement physique et les caractéristiques électriques de la puce. Les cartes à puce à contact ne contiennent généralement pas de batteries est fournie par le lecteur de carte pour les fonctions effectuées sur la puce. Les cartes à puce de contact ont généralement des protocoles de communication standard, de sorte qu'une carte à puce peut être utilisée dans différents lecteurs et que des transactions peuvent être effectuées. Les cartes à puce à contact sont utilisées comme moyen de communication entre une carte à puce et un hôte, et cet hôte peut être un ordinateur, un terminal de point de vente, un téléphone mobile, un point d'entrée de transit, un téléphone public, etc.

Un autre type de carte de transaction est appelé carte à puce sans contact, ou encore carte sans contact. Une carte à puce sans contact contient une puce qui communique avec un lecteur de carte via la technologie d'induction RFID. Une carte à puce sans contact ne nécessite que la proximité d'une antenne pour mener à bien la transaction. Une carte à puce sans contact est généralement définie par les dimensions d'une carte de transaction standard, par exemple, ISO/IEC 7816, et aura un protocole de communication normalisé, par exemple tel que défini par l'ISO/IEC 1443. En règle générale, une carte à puce sans contact peut être utilisée pour des communications à des distances allant jusqu'à dix centimètres. La norme ISO/IEC 15693 pour les cartes à puce sans contact est celle qui permet la communication à des distances allant jusqu'à 50 centimètres. D'autres normes peuvent être disponibles sur de plus grandes distances pour des applications telles que le transport en commun et les routes à péage

Une carte de transaction peut contenir plusieurs technologies. Par exemple, une carte de transaction peut comporter une bande magnétique et une puce. Une carte de transaction peut comporter une bande magnétique, une puce et une interface sans contact sur une seule carte. Une carte à puce peut avoir une puce et une interface sans contact sur une carte. Parfois, une carte de transaction comportant une bande magnétique et au moins une puce peut être appelée carte à puce hybride.

Pour s'accommoder des différences qui peuvent exister entre les technologies de carte de transaction, des constructeurs fournissent différents lecteurs de cartes de transaction. Typiquement, un terminal de paiement classique, que l'on trouve chez les commerçants (Retail), comprend un lecteur de carte à bande magnétique, généralement situé sur le côté droit du terminal de paiement et se présente sous la forme d'une fente dans laquelle la carte à bande magnétique peut être glissée. Un terminal de paiement classique comprend également un lecteur de carte à puce, qui se situe sur le devant du terminal, sous le clavier, et dans lequel la carte à puce est insérée. Un terminal de paiement classique peut également comprendre un lecteur de carte sans contact qui est située en haut de l'écran d'affichage et sur lequel l'utilisateur peut apposer une carte sans contact ou un autre dispositif sans contact (montre intelligente, smartphone, etc.).

Pour répondre à des contraintes spécifiques, des constructeurs peuvent également proposer des lecteurs hybrides. Un lecteur hybride est, à l'instar d'une carte de transaction hybride, un lecteur qui supporte au moins deux technologies différentes. Il s'agit par exemple d'un lecteur comprenant des moyens de lecture d'une puce d'une carte à puce et des moyens de lecture d'une bande d'une carte à bande magnétique. De tels lecteurs hybrides peuvent par exemple être intégrés dans des machines automatiques de vente (de type pompe de station essence, distributeurs divers) ou encore dans des distributeurs automatiques de billet (DAB/ATM).

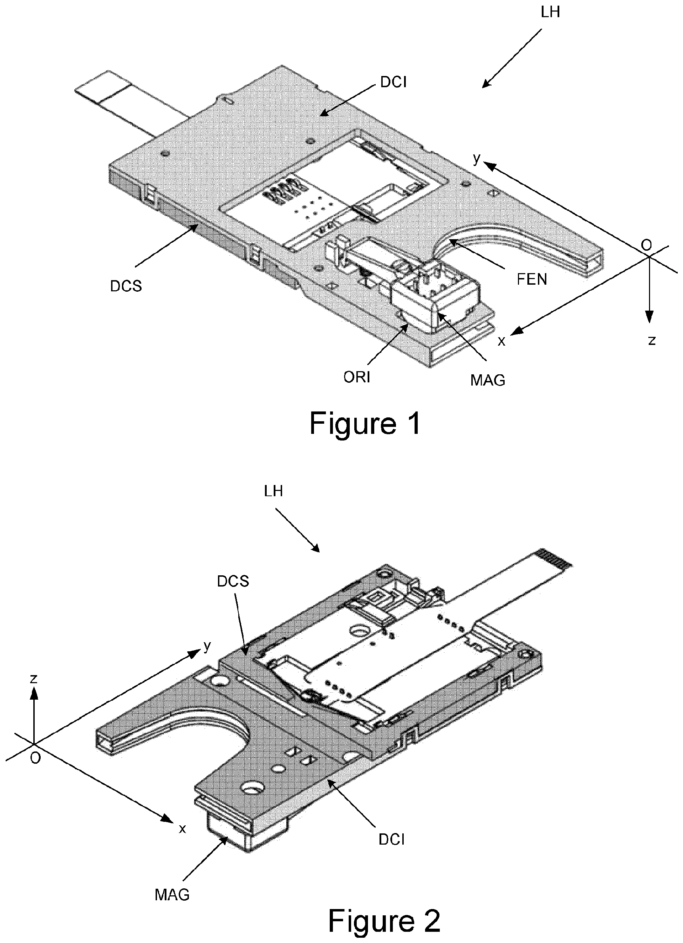

Un exemple d'un lecteur hybride typique est présenté en figures 1 et 2. Un lecteur hybride se présente sous la forme d'un parallélépipède rectangle, dont les dimensions en largeur avoisinent celles d'une carte de transaction définie selon la norme 7810 ID1/ID2. Les dimensions en longueur sont généralement très supérieures à celles de la longueur de de la carte de transaction. Le lecteur comprend une face supérieure (demi capot supérieur DCS) et une face inférieure (demi capot inférieur DCI). Ces deux capots (supérieur/inférieur) sont assemblés afin de former un lecteur hybride (LH), comprenant une fente d'insertion FEN d'une carte de transaction. Le capot supérieur comprend des éléments permettant d'effectuer une lecture d'une puce d'une carte à puce, tandis que le capot inférieur comprend une tête de lecture magnétique. Plus particulièrement, le capot inférieur DCI comprend un orifice ORI permettant à une tête de lecture magnétique (MAG) de pivoter entre une position de lecture (position dans laquelle la tête est en contact avec une carte de transaction et une position dite de repos, position dans laquelle la surface supérieure (généralement bombée) de la tête magnétique pénètre légèrement au sein de l'espace d'insertion de la carte à mémoire. Le capot supérieur comprend quant à lui un connecteur de carte à mémoire qui comprend notamment un certain nombre de « pins », chaque « pin » correspondant à une zone de contact d'une puce d'une carte à puce. La position du connecteur est conformée de sorte que les « pins » entrent en contact avec les zones de la puce lorsque la carte est complètement enfoncée dans le lecteur hybride (et lorsque la carte de transaction comprend une puce, bien entendu).

Ainsi, de tels lecteurs comprennent une tête de lecture magnétique présente au niveau d'emplacement supposé de la bande de la carte à bande magnétique (ou delà carte hybride) selon les normes 7810/7811. Cette tête magnétique est généralement située en zone inférieure du lecteur. Ils comprennent également un connecteur de carte à puce situé en zone supérieure selon les normes 7810/7816.

En termes de fonctionnement, de tels lecteurs hybrides apportent satisfaction (c'est-à-dire qu'ils sont capables de reconnaitre une carte à puce d'une carte à bande magnétique et de basculer sur l'une ou l'autre des technologies en fonction de la carte de transaction qui est présentée). Cependant, ils souffrent de défauts liés à leur fabrication, notamment au niveau de la sécurité et de la compacité.

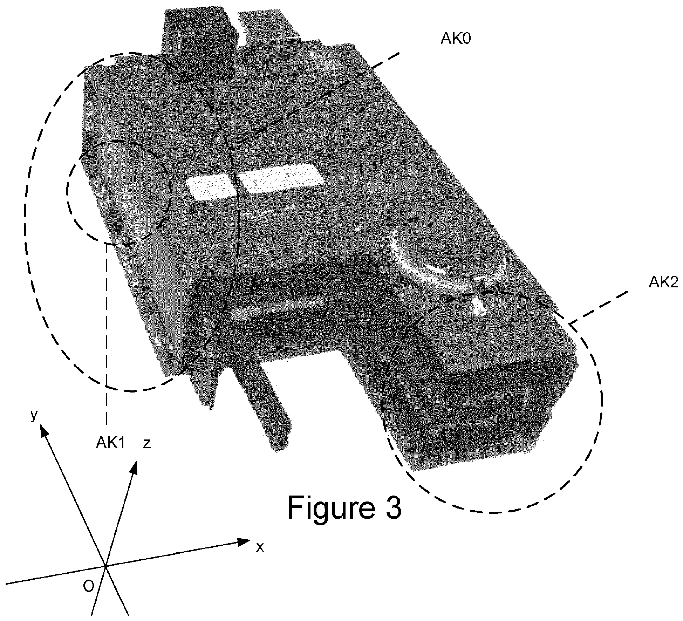

Au niveau de la sécurité, tout d'abord, comme cela est visible sur les figures 1 et 2, de tels lecteurs n'offrent pas de protection suffisante contre les attaques, notamment contre l'insertion d'un « bug » au niveau de la tête de lecture magnétique ou au niveau du connecteur de carte à puce. La figure 1, notamment monte clairement que ces deux parties du lecteur hybrides sont aisément accessibles. Il est donc possible, à partir de l'extérieur du lecteur (à partir de la fente d'insertion de la carte de transaction), d'insérer un ou plusieurs dispositifs de lecture frauduleux (appelé « bug »), afin de pouvoir lire frauduleusement les données des cartes qui sont insérées au sien du terminal en fonctionnement. Pour pallier ces problèmes, les constructeurs positionnent ainsi, autour du lecteur, de volumineux parallélépipèdes de circuits imprimés (ref AKO, figure 3), appelés coffres, censés faire barrière aux tentatives d'insertion de bugs ou de dispositifs espions. Cependant, ces coffres sont soudés autour du lecteur hybride, comme exposé en figure 3 (ref AK1, figure 3). Il en résulte un lecteur hybride plus ou moins protégé : on peut noter que la protection n'est pas parfaite, particulièrement au niveau de la fente d'insertion (au-dessus de cette fente et en dessous de cette fente). Par ailleurs, pour protéger la tête magnétique et son mécanisme de basculement, qui forment un ensemble volumineux, la « protection » est étendue sur le côté droit du lecteur, comme indiqué en figure 3. Plus particulièrement, le lecteur hybride est emmuré dans une construction à base de circuits imprimés à l'horizontal (circuit imprimé supérieur et circuit imprimé inférieur) ces deux circuits imprimés supérieurs et inférieur étant soudés à des circuits imprimés verticaux situés à l'arrière du lecteur et sur les deux côtés gauche et droite du lecteur. Les points de soudure permettant l'obtention d'un tel coffrage sont nombreux, entrainant d'une part une difficulté de fabrication et une difficulté de maintenance globale d'un tel système : en cas de défaillance à l'intérieur du coffrage, il est nécessaire de dessouder l'ensemble, manuellement, ce qui entraine une perte de temps importante et de nombreux rebus et déchets.

Au niveau de la compacité, ensuite, un tel lecteur nécessite, comme cela à nouveau est visible en figures 1, 2 et 3, de disposer d'une épaisseur suffisante notamment pour que la tête de lecture magnétique ait suffisamment d'espace (ref AK2, figure 3). Cet espace est en effet nécessaire au mouvement de basculement de la tête lors de l'insertion d'une carte de transaction. L'espace nécessaire est encore augmenté du fait du volume de la tête de lecture elle-même. Cet espace entraine une hauteur importante des parois verticales de protection sur l'ensemble du pourtour du lecteur hybride.

Au final, le système obtenu (constitué du lecteur hybride et de sa protection sous la forme de circuits imprimés montés et soudés en forme de barrières verticales et horizontales) est trop volumineux pour certaines applications et est trop peu sécurisé.

Par ailleurs, les documents US 2010/327856 et EP 1 432 031 décrivent des cartes de circuit imprimé comportant une enceinte totalement fermée pour protéger certain des composants électroniques disposés sur ces cartes de circuit imprimé. En outre, le document EP 1432 031 décrit un terminal de paiement incluant un lecteur de carte magnétique et un lecteur de carte à puce.

Il existe donc un besoin de fournir un lecteur hybride qui soit compact et sécurisé.

### 3. Résumé

La technique divulguée a été créée en conservant ces inconvénients de l'art antérieur à l'esprit.

Plus particulièrement, il est proposé un système de lecture hybride de carte de transaction comprenant un lecteur hybride de carte de transaction, un dispositif de protection et une fente d'insertion d'une carte de transaction, le lecteur hybride de carte de transaction comprenant des moyens de lecture d'une piste magnétique et des moyens de lecture d'une puce, le dispositif de protection comprenant un circuit imprimé de protection supérieur, un circuit imprimé de protection inférieur et un circuit imprimé de protection latéral, le circuit imprimé de protection latéral comprenant une superposition de circuits imprimés unitaires, le plan de superposition des circuits imprimés unitaires étant parallèle au plan du circuit imprimé de protection supérieur et au plan du circuit imprimé de protection inférieur.

Un tel système est remarquable en ce que les moyens de lecture d'une puce sont disposés entre le circuit imprimé de protection supérieur, le circuit imprimé de protection inférieur et le circuit imprimé de protection latéral.

Ainsi, la technique proposée permet de rendre le système objet de la présente beaucoup plus compact et sécurisé que les solutions de l'art antérieur.

Selon un mode de réalisation particulier, le circuit imprimé de protection latéral comprend une pluralité de portions indépendantes, soudées ou vissées sur le circuit imprimé de protection supérieur et/ou sur le circuit imprimé de protection inférieur.

Ainsi, le système de l'invention est plus simple à construire et à monter. Les couts de fabrication d'un terminal embarquant un tel système sont donc moindres, tout en facilitant la mise en œuvre.

Selon une caractéristique particulière, le circuit imprimé de protection latéral comprend au moins un orifice de passage de vis d'assemblage.

Ainsi, le système proposé est beaucoup plus simple à maintenir.

Selon une caractéristique particulière, le circuit imprimé de protection latéral comprend au moins un orifice de positionnement d'au moins un connecteur élastomère.

Ainsi, la sécurité du système est améliorée en assurant que tout démontage du système entraine une détente du connecteur élastomère présent, et donc une perte du signal de sécurisation et par voie de conséquence une détection immédiate de la fraude, permettant la mise en œuvre de mesures de sécurisation.

Selon une caractéristique particulière, les moyens de lecture d'une piste magnétique du lecteur hybride comprennent une tête de lecture magnétique et un système de basculement inversé au sein duquel la tête de lecture magnétique est insérée.

Ainsi, la compacité de la tête de lecture est améliorée.

Selon un mode de réalisation particulier, la tête de lecture magnétique comprend des moyens de connexion à une nappe de transmission de signaux.

Selon un mode de réalisation particulier, la nappe de transmission de signaux comprend un circuit imprimé flexible multicouches, la couche externe du circuit imprimé flexible multicouches comprenant un treillis de protection.

Ainsi, la tête de lecture magnétique est sécurisée de manière autonome.

Selon un mode de réalisation particulier, les dimensions du dispositif de protection sont conformées de sorte à protéger l'accès aux moyens de lecture de puce.

### 4. Présentation des dessins

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :
- la figure 1, déjà présentée, illustre l'architecture d'une lecteur hybride de l'art antérieur ;
- la figure 2, déjà présentée, est une autre représentation de l'architecture d'une lecteur hybride de l'art antérieur ;
- la figure 3, déjà présentée, illustre un système de lecture hybride de l'art antérieur, comprenant un lecteur hybride tel que celui présenté en figures 1 et 2 et un dispositif de protection de ce lecteur hybride ;
- la figure 4 illustre un système de lecture hybride selon l'invention, dans une vue isométrique ;
- la figure 5 est un éclaté du système de lecture hybride selon l'invention dans un premier mode de réalisation ;
- la figure 6 est un éclaté du système de lecture hybride selon l'invention dans un deuxième mode de réalisation, intégrant une unité processeur de traitement de données de transaction ;
- la figure 7 illustre un circuit imprimé de protection latéral selon l'invention ;
- la figure 8 illustre également un circuit imprimé de protection latéral selon l'invention ;
- la figure 9 illustre le système de basculement de tête magnétique selon l'invention.

### 5. Présentation de l'invention

Dans ce qui précède et ce qui suit, les descriptions réalisées sont effectuées par rapport à un référentiel de type (O, x, y, z). Les éléments qualifiés de « supérieurs » ont, par rapport à ce référentiel une altitude (z) supérieure aux éléments qualifiés « d'inférieurs ». Les notions de gauche, droite, haut et bas sont également à comprendre comme se référant à ce repère orthonormal (O, x, y, z). Ainsi la partie gauche du lecteur hybride est celle dont l'abscisse est la plus proche de O tandis la partie droite du lecteur hybride est celle dont l'abscisse est la plus éloignée de O. La partie avant du lecteur hybride est celle dont l'ordonnée est la plus proche de O tandis la partie arrière du lecteur hybride est celle dont l'ordonnée est la plus éloignée de O. Le même référentiel est utilisé pour la description des éléments composants le lecteur hybride, tel que la tête de lecture magnétique, les circuits imprimés, les nappes, etc.

Pour pallier les inconvénients de l'art antérieur, tels que précédemment exposés, les inventeurs ont réalisé une lecteur hybride compact, qui est en phase avec les impératifs de protection des signaux émis et reçus par les cartes de transaction d'une part ; et par la nécessaire réduction de taille de l'ensemble d'autre part, afin de répondre aux besoins de réduction de ces lecteurs. La compacité et la sécurité sont des fonctions qui sont assurées par un système comprenant un lecteur hybride compact et un ensemble de circuits imprimés en couches parallèles, assurant une protection globale en partie supérieure, inférieure et périphérique du lecteur hybride. Ainsi, à la différence d'un dispositif de l'art antérieur, qui possède une carte supérieure, une carte inferieure et trois cartes de côté, et dans lequel toutes les cartes sont protégées par des treillis, les treillis ne peuvent cependant pas s'étendre jusqu'au bord des cartes : il reste un espace de 0.5 mm à la jonction des cartes qui n'est pas protégé par le treillis, et qui rend le dispositif de l'art antérieur vulnérable.

Dans le dispositif de l'invention, les cartes supérieure et inferieure disposent d'un treillis. Les cartes de côté sont remplacées par des « bunkers » qui n'ont pas de treillis mais des vias ce qui crée une barrière infranchissable sans espace avec les cartes inférieure et supérieure. La sécurité est bien meilleure, tout en obtenant un dispositif beaucoup plus compact. De plus, les vias et les treillis peuvent être alternativement connectés, par exemple par paires, pour utiliser une alternance dans les signaux de sécurité qui transitent au sien de ces circuits (treillis, vias) et donc pour permettre de se prémunir d'un perçage latéral, ce qui augmente encore le niveau de sécurisation.

Par ailleurs, les inventeurs ont éliminé le besoin de protection au niveau de la tête de lecteur magnétique du lecteur hybride en modifiant l'architecture de positionnement de la tête de lecteur magnétique. Plus particulièrement, les inventeurs ont réduit la hauteur nécessaire à la protection du lecteur hybride de l'art antérieur en proposant un mécanisme alternatif de protection de la tête de lecture magnétique. Comme la tête de lecture magnétique est protégée de manière différente (par rapport à la protection latérale de l'art antérieur), il est donc possible de réduire la hauteur de la protection du lecteur hybride à la seule hauteur du lecteur hybride, sans tenir compte de la hauteur et du débattement de la tête de lecteur magnétique, et donc d'obtenir un lecteur hybride beaucoup plus compact. Plus particulièrement, la tête n'est plus dans l'enveloppe de sécurité créée par des cartes, elle est sécurisée de façon autonome (double treillis sur le FPC), ce qui permet la réduction de hauteur du lecteur.

Ainsi, selon l'invention, on combine astucieusement une modification du mécanisme de basculement de la tête de lecture magnétique avec un dispositif de protection latéral du lecteur hybride innovant. Cette combinaison est effectuée pour réduire la taille du système composé du lecteur hybride compact et des circuits imprimés de protection tout en augmentant drastiquement la sécurité de l'ensemble ainsi obtenu.

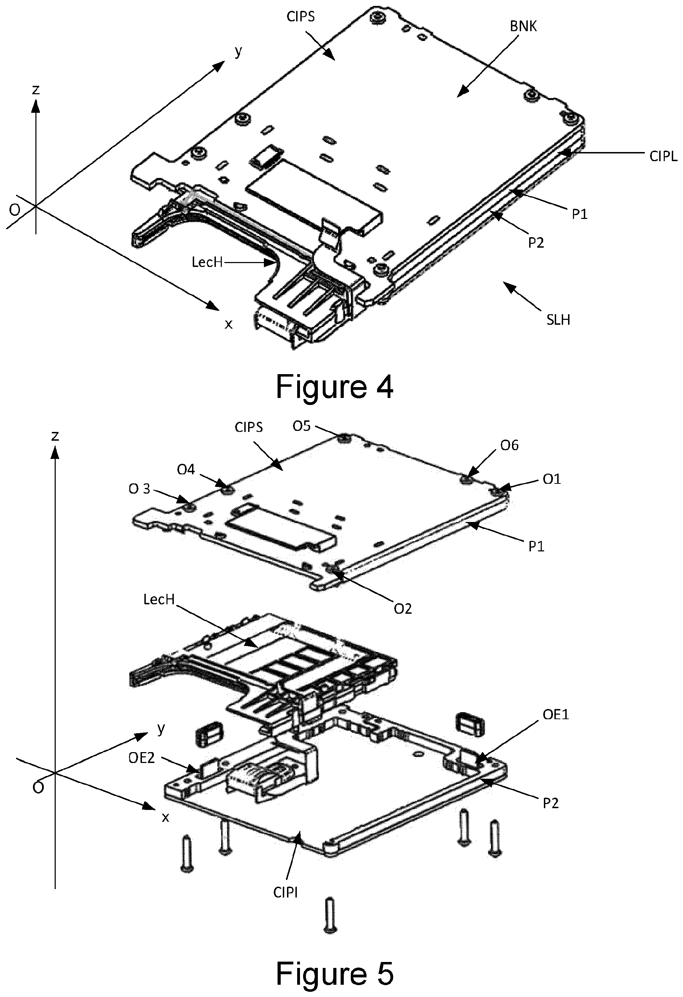

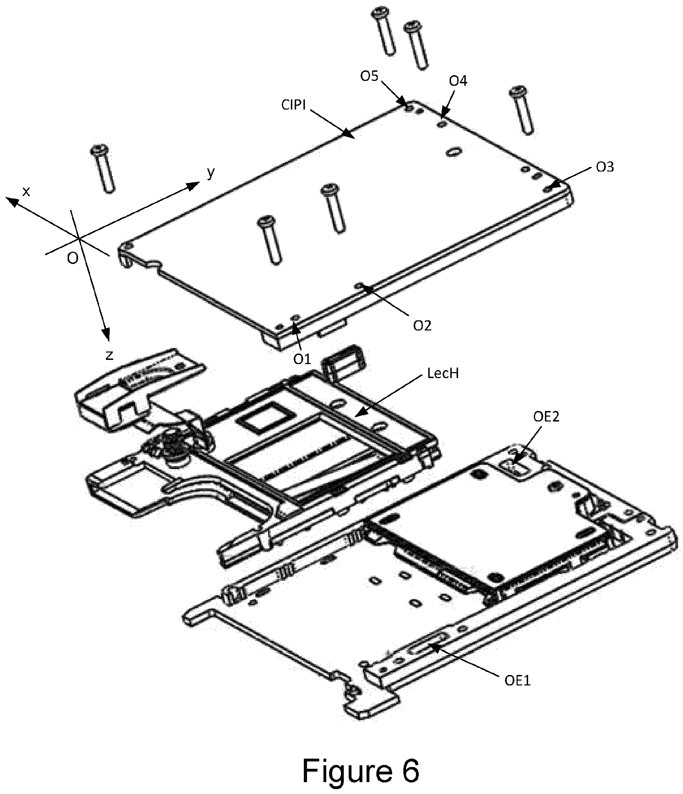

Plus particulièrement, comme décrit en relation avec les figures 4, 5 et 6, le système selon l'invention comprend un lecteur hybride (LECH), un circuit imprimé de protection supérieur (CIPS), un circuit imprimé de protection inférieur (CIPI) et un circuit imprimé de protection latéral (CIPL). Dans l'exemple donné aux figures 4, 5 et 6, le circuit imprimé de protection latéral (CIPL) est divisé en deux parties distinctes : circuit imprimé de protection latéral supérieur (CIPLS), qui est intégré/associé parallèlement au circuit imprimé de protection supérieur (CIPS), et un circuit imprimé de protection latéral inférieur (CIPLI), qui est intégré/associé parallèlement au circuit imprimé de protection inférieur (CIPI). Dans cet exemple de réalisation, le découpage en deux parties du circuit imprimé de protection latéral (CIPL) est effectué à mi-hauteur de celui-ci, et le circuit imprimé de protection latéral supérieur (CIPLS) est une partie du circuit imprimé de protection supérieur (CIPS). De même le circuit imprimé de protection latéral inférieur (CIPLI) est une partie du circuit imprimé de protection inférieur (CIPI).

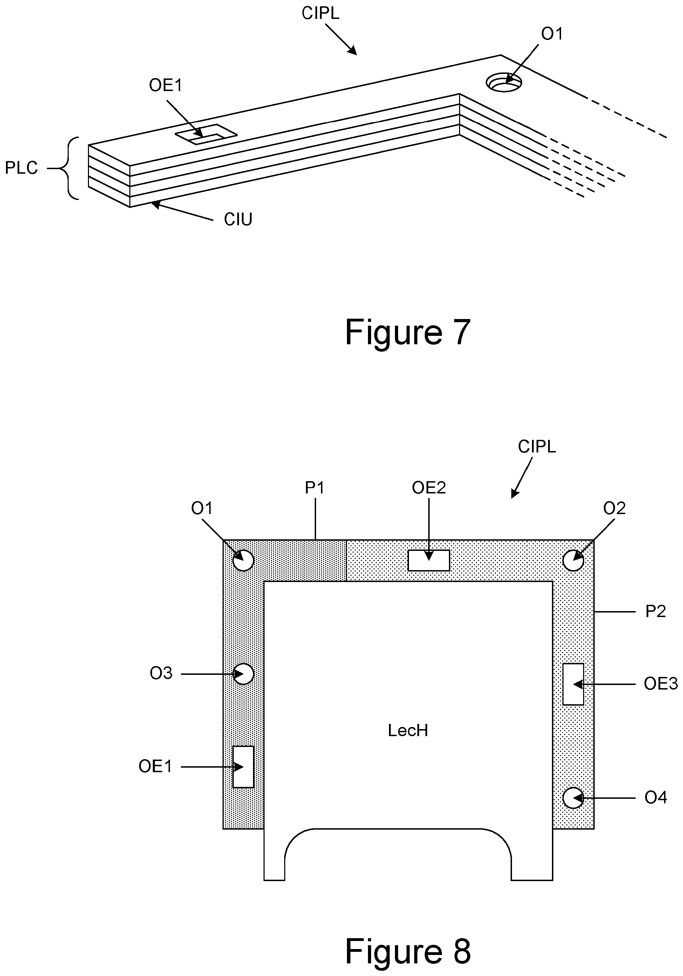

Il est compris que dans d'autres exemples ou modes de réalisation le circuit imprimé de protection latéral (CIPL) peut prendre la forme d'une pièce indépendante du circuit imprimé de protection supérieur (CIPS) et/ou du circuit imprimé de protection inférieur (CIPI). Il est compris que dans d'autres exemples ou modes de réalisation le circuit imprimé de protection latéral (CIPL) peut, dans son intégralité, être une partie du circuit imprimé de protection supérieur (CIPS) ou du circuit imprimé de protection inférieur (CIPI). Des détails sur le circuit imprimé de protection latéral (CIPL) sont décrits en relations avec les figures 7 et 8.

Quelle que soit la mise en œuvre de ce circuit imprimé de protection latéral (CIPL), il présente la caractéristique principale d'être constitué d'une pluralité de couches (PLC) de circuit imprimé individuel (de quatre à huit couches), chaque couche de circuit imprimé étant empilée parallèlement sur la précédente, afin de former un mur. Les couches sont connectées les unes aux autres par l'intermédiaire de vias (non représentées), qui permettent la transmission de signaux de sécurité entre les couches. En d'autres termes, le dispositif de protection du lecteur hybride comprend un circuit imprimé de protection latéral (découpé en une ou plusieurs parties) qui comprend une superposition de circuits imprimés unitaires, le plan de superposition de ces circuits imprimés unitaires étant parallèle au plan du circuit imprimé de protection supérieur et au plan du circuit imprimé de protection inférieur. Chaque couche peut individuellement comprendre un ou plusieurs treillis de protection (non représentée), reliés par exemple à la masse, afin de permettre une détection d'un éventuel perçage ou laminage. La géométrie du circuit imprimé de protection latéral (CIPL) est adaptée au volume du lecteur hybride. Plus particulièrement, la forme interne (c'est-a-dire la forme des parois qui se trouvent au plus près du lecteur hybride LecH) est conformée pour limiter les interstices potentiels au sein du « bunker » formé par le circuit imprimé de protection latéral (CIPL), le circuit imprimé de protection supérieur (CIPS) et le circuit imprimé de protection inférieur (CIPI) (la géométrie est évidemment simplifiée en figure 8). Le circuit imprimé de protection latéral (CIPL) comprend des orifices (O1, O2, O3, O4, etc.) permettant le passage de vis d'assemblage (voir par la suite) et des orifices (OE1, OE2, etc.) de positionnement de connecteurs élastomères. Ces connecteurs élastomères permettent une transmission de signaux de sécurité par exemple entre circuit imprimé de protection supérieur (CIPS) et le circuit imprimé de protection inférieur (CIPI) pour permettre une détection de toute tentative d'ouverture non autorisée du système. En fonction des modes de réalisation, les circuits imprimés de protection supérieur (CIPS) et le circuit imprimé de protection inférieur (CIPI) peuvent avoir d'autres fonctions que des fonctions de protection. Il peut par exemple s'agir de cartes embarquant des fonctions de communication inter UC ou encore des fonctions d'alimentation.

De plus, selon l'invention, le « bunker » formé par le circuit imprimé de protection latéral (CIPL), le circuit imprimé de protection supérieur (CIPS) et le circuit imprimé de protection inférieur (CIPI) est monté à l'aide de vis d'assemblage, qui sont utilisées pour pallier l'inconvénient de la solution antérieure consistant à souder les parois latérales (et donc pallier le problème d'absence de maintenabilité). De cette manière, la maintenabilité du système est préservée. On note que ce type de montage, à l'aide de vis, n'est rendu possible que grâce à la mise en œuvre du circuit imprimé de protection latéral (CIPL) tel que précédemment décrite. En effet, l'utilisation de plusieurs couches parallèles de circuits imprimés pour former le circuit imprimé de protection latéral (CIPL) permet de disposer d'une épaisseur suffisante pour y aménager des orifices de vis permettant de solidariser l'ensemble, ce qui n'est pas possible avec les solutions de l'art antérieur. Le circuit imprimé de protection latéral (CIPL) peut être constitué de plusieurs portions (P1, P2, etc.) indépendantes, qui sont assemblées une à une parallèlement sur le circuit imprimé de protection supérieur (CIPS) et/ou le circuit imprimé de protection inférieur (CIPI) afin de faciliter d'une part la fabrication du circuit imprimé de protection latéral (CIPL) et d'autre part le montage de celui-ci. L'avantage, pour la fabrication, réside dans la relative facilitée de fabrication de telle portions, relativement rectilignes, ne nécessitant pas de dessins trop complexes. Par ailleurs, une telle fabrication est avantageuse au niveau du coût car elle évite de devoir payer pour de la matière perdue (i.e. pour les portions de circuit imprimé découpées, qui bien qu'étant mise au rebus sont tout de même facturées). Du point de vue du montage, également une telle manière de procéder est intéressante car elle permet de positionner successivement et parallèlement les différentes portions, sans difficulté excessive d'alignement. Le bunker permet de protéger l'ensemble des fonctions mises en œuvre au niveau du connecteur de carte à puce. Les fonctions de lecture au niveau de la tête magnétique sont dépourvues de la protection apportée par le bunker. Par voie de conséquence, le bunker à globalement la forme d'un parallélépipède rectangle, sans la protubérance au niveau de la tête de lecture magnétique.

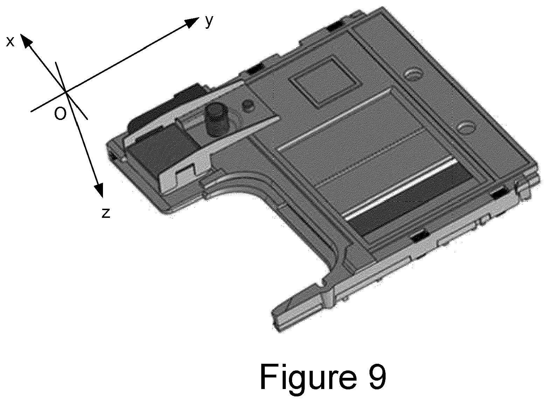

De plus, selon l'invention, un lecteur hybride comprend une tête de lecture magnétique compacte, associé à un système de basculement inversé. Par compacte, on entend une tête de lecture magnétique dont la longueur et la largeur sont respectivement comprises entre 10 et 20 millimètres et dont la hauteur est comprise entre 5 et 15 millimètres. L'association de ces deux caractéristiques permet de réduire de moitié l'épaisseur nécessaire à la mise en œuvre de la tête magnétique et donc de répondre à l'impératif de compacité et à celui de sécurité, comme cela est explicité par la suite, en relation avec la figure 9. Pour ce qui est de la compacité, la construction inversée du système de basculement de la tête de lecture magnétique comprend un support de tête magnétique, de forme longitudinale, comprenant une portion de solidarisation, permettant d'enserrer et de maintenir la tête de lecture magnétique. Dans le mode de réalisation présenté, la portion de solidarisation comprend quatre pattes de serrage, deux de chaque côté de la tête. La portion de solidarisation est suivie d'une portion plane, comprenant deux orifices : le premier orifice est utilisé pour accueillir un plot de soutien d'un moyen de rappel (ici un ressort), le plot de soutien comprenant à sa base un disque d'arrêt du moyen de rappel. Ainsi, lorsque la tête est mise en mouvement, par exemple par l'insertion d'une carte, la tête est dégagée pour accueillir la carte, puis, lorsque la carte est retirée, le moyen de rappel inversé permet à la tête de lecture magnétique de reprendre sa place dans l'orifice qui lui est assigné. L'avantage de ce mode de réalisation est qu'il n'est pas prévu de système de basculement, comme dans les lecteur hybrides de l'art antérieur, mais au lieu de cela un système de translation, autorisant ainsi l'utilisation d'un moyen de rappel d'une hauteur moins élevée, et permettant au final l'obtention d'un lecteur hybride d'une plus faible épaisseur. En comparaison avec le dispositif de la figure 1, la réduction de la hauteur est de plus de 50%. Par ailleurs, la technique employée permet aussi d'augmenter la sécurité.

Pour ce qui est de la tête de lecture magnétique elle-même, la connexion de celle-ci à une carte de circuit imprimé est réalisée par l'intermédiaire d'une nappe, prenant la forme d'un circuit imprimé flexible. Cette nappe est connectée à la tête de lecture magnétique par le dessous de celle-ci, avec la particularité de dégager la nappe de connexion vers l'extérieur (côté droit) du lecteur hybride. De cette manière, il n'est pas possible d'avoir accès aux signaux par le dessous de la tête magnétique (art antérieur). Au contraire, la nappe qui est connectée latéralement à la tête magnétique est conformée pour être connectée à une portion sécurisée du système hybride de l'invention. Selon l'invention, la nappe consiste en un circuit imprimé flexible multicouches (au moins double couche), dans lequel la couche externe (c'est-à-dire la couche qui ne transposte pas les signaux issus de la lecture de la carte magnétique), comprend un treillis de protection. De cette manière, les signaux issus de bandes magnétique ne sont pas accessibles en introduisant un bug par-dessous la tête de lecture magnétique, comme dans l'exemple de la figure 1 ou 2. Ainsi, la compacité du système de lecture hybride (SLH) ne contrevient pas à la sécurité des signaux qui sont issus de la tête magnétique. Par ailleurs, le treillis de protection de cette nappe est connecté à un mécanisme de détection d'intrusion, impliquant le déclenchement d'une mesure de protection du système de lecture hybride en cas de tentative de laminage ou de perçage de ce flexible. De plus, même si l'attaquant tente l'insertion d'un bug au niveau de la tête magnétique, celle-ci est empêchée. En effet, si le bug est placé devant la tête, une attaque connue est de venir plaquer une fausse face avant mais la carte va trop s'enfoncer et ne pourra pas être ressortie, grâce à la mise en œuvre proposée. C'est donc une amélioration plus qu'efficace pour bloquer ce type de tentative. Enfin, le bug ne peut pas être placé derrière la tête (ce qui est possible avec l'ancien lecteur des figures 1 et 2).

## Revendications

1. Système de lecture hybride (SLH) de carte de transaction comprenant un lecteur hybride (LecH) de carte de transaction, un dispositif de protection (BNK) et une fente d'insertion (FEN) d'une carte de transaction, le lecteur hybride de carte de transaction comprenant des moyens de lecture d'une piste magnétique et des moyens de lecture d'une puce, le dispositif de protection comprenant un circuit imprimé de protection supérieur (CIPS), un circuit imprimé de protection inférieur (CIPI) et un circuit imprimé de protection latéral (CIPL), le circuit de protection latéral comprenant une superposition (PLC) de circuits imprimés unitaires (CIU), le plan de superposition des circuits imprimés unitaires (CIU) étant parallèle au plan du circuit imprimé de protection supérieur (CIPS) et au plan du circuit imprimé de protection inférieur (CIPI),
**caractérisé en ce que** les moyens de lecture d'une puce sont disposés entre le circuit imprimé de protection supérieur (CIPS), le circuit imprimé de protection inférieur (CIPI) et le circuit imprimé de protection latéral (CIPL).

2. Système de lecture hybride (SLH) de carte de transaction selon la revendication 1, **caractérisé en ce que** le circuit imprimé de protection latéral (CIPL) comprend une pluralité de portions indépendantes (P1, P2), soudées ou vissées sur le circuit imprimé de protection supérieur (CIPS) et/ou sur le circuit imprimé de protection inférieur (CIPI).

3. Système de lecture hybride (SLH) de carte de transaction selon la revendication 1 ou 2, **caractérisé en ce que** le circuit imprimé de protection latéral (CIPL) comprend au moins un orifice (O1, O2, O3, O4, O5, O6) de passage de vis d'assemblage.

4. Système de lecture hybride (SLH) de carte de transaction selon l'une des revendications 1 à 3, **caractérisé en ce que** le circuit imprimé de protection latéral (CIPL) comprend au moins un orifice (OE1, OE2) de positionnement d'au moins un connecteur élastomère.

5. Système de lecture hybride (SLH) de carte de transaction selon l'une des revendications 1 à 4, **caractérisé en ce que** les moyens de lecture d'une piste magnétique comprennent une tête de lecture magnétique et un système de basculement inversé au sein duquel la tête de lecture magnétique est insérée.

6. Système de lecture hybride (SLH) de carte de transaction selon la revendication 5, **caractérisé en ce que** la tête de lecture magnétique comprend des moyens de connexion à une nappe de transmission de signaux.

7. Système de lecture hybride (SLH) de carte de transaction selon la revendication 6, **caractérisé en ce que** la nappe de transmission de signaux comprend un circuit imprimé flexible multicouches, la couche externe du circuit imprimé flexible multicouches comprenant un treillis de protection.

8. Système de lecture hybride (SLH) de carte de transaction selon l'une des revendications 1 à 7, **caractérisé en ce que** les dimensions du dispositif de protection (BNK) sont conformées de sorte à protéger l'accès aux moyens de lecture de puce.

## Patentansprüche

1. Hybridlesesystem (SLH) für Transaktionskarten, umfassend einen Hybridleser (LecH) für Transaktionskarten, eine Schutzvorrichtung (BNK) und einen Steckplatz (FEN) für eine Transaktionskarte, wobei der Hybridleser für Transaktionskarten Lesemittel für eine Magnetspur und Lesemittel für einen Chip umfasst, wobei die Schutzvorrichtung eine obere Schutzplatine (CIPS), eine untere Schutzplatine (CIPI) und eine seitliche Schutzplatine (CIPL) umfasst, wobei die seitliche Schutzplatine eine Überlagerung (PLC) von Einheitsplatinen (CIU) umfasst, wobei die Überlagerungsebene der Einheitsplatinen (CIU) parallel zur Ebene der oberen Schutzplatine (CIPS) und zur Ebene der unteren Schutzplatine (CIPI) verläuft,
**dadurch gekennzeichnet, dass** die Lesemittel für einen Chip zwischen der oberen Schutzplatine (CIPS), der unteren Schutzplatine (CIPI) und der seitlichen Schutzplatine (CIPL) angeordnet sind.

2. Hybridlesesystem (SLH) für Transaktionskarten nach Anspruch 1, **dadurch gekennzeichnet, dass** die seitliche Schutzplatine (CIPL) eine Vielzahl von unabhängigen Abschnitten (P1, P2) umfasst, die an die obere Schutzplatine (CIPS) und/oder an die untere Schutzplatine (CIPI) geschweißt oder geschraubt sind.

3. Hybridlesesystem (SLH) für Transaktionskarten nach Anspruch 1 oder 2, **dadurch gekennzeichnet, dass** die seitliche Schutzplatine (CIPL) mindestens eine Öffnung (O1, O2, O3, O4, O5, O6) zur Durchführung von Verbindungsschrauben umfasst.

4. Hybridlesesystem (SLH) für Transaktionskarten nach einem der Ansprüche 1 bis 3, **dadurch gekennzeichnet, dass** die seitliche Schutzplatine (CIPL) mindestens eine Öffnung (OE1, OE2) zur Positionierung von mindestens einem Elastomeranschluss umfasst.

5. Hybridlesesystem (SLH) für Transaktionskarten nach einem der Ansprüche 1 bis 4, **dadurch gekennzeichnet, dass** die Lesemittel einer Magnetspur einen magnetischen Lesekopf und ein Umschaltsystem umfassen, in das der magnetische Lesekopf eingesetzt ist.

6. Hybridlesesystem (SLH) für Transaktionskarten nach Anspruch 5, **dadurch gekennzeichnet, dass** der magnetische Lesekopf Verbindungsmittel zu einer Signalübertragungsmatte umfasst.

7. Hybridlesesystem (SLH) für Transaktionskarten nach Anspruch 6, **dadurch gekennzeichnet, dass** die Signalübertragungsmatte eine mehrlagige flexible Leiterplatte umfasst, wobei die äußere Schicht der mehrlagigen flexiblen Leiterplatte ein Schutzgitter umfasst.

8. Hybridlesesystem (SLH) für Transaktionskarten nach einem der Ansprüche 1 bis 7, **dadurch gekennzeichnet, dass** die Abmessungen der Schutzeinrichtung (BNK) so ausgelegt sind, dass der Zugang zu den Chiplesemitteln geschützt ist.

## Claims

1. A hybrid transaction card reading system (SLH) comprising a hybrid transaction card reader (LecH), a protection device (BNK) and an insertion slot (FEN) for a transaction card, the hybrid transaction card reader comprising means for reading a magnetic track and means for reading a chip, the protection device comprising an upper protection printed circuit (CIPS), a lower protection printed circuit (CIPI) and a lateral protection printed circuit (CIPL), the lateral protection circuit comprising a superposition (PLC) of unitary printed circuits (CIU), the plane of superposition of the unitary printed circuits (CIU) being parallel to the plane of the upper protection printed circuit (CIPS) and to the plane of the lower protection printed circuit (CIPI),
**characterized in that** the means for reading a chip are disposed between the upper protection printed circuit (CIPS), the lower protection printed circuit (CIPI) and the lateral protection printed circuit (CIPL).

2. The hybrid transaction card reading system (SLH) according to claim 1, **characterized in that** the lateral protection printed circuit (CIPL) comprises a plurality of independent portions (P1, P2), welded or screwed onto the upper protection printed circuit (CIPS) and/or onto the lower protection printed circuit (CIPI).

3. The hybrid transaction card reading system (SLH) according to claim 1 or 2, **characterized in that** the lateral protection printed circuit (CIPL) comprises at least one opening (01, O2, O3, O4, O5, O6) for passing assembly screws.

4. The hybrid transaction card reading system (SLH) according to any of claims 1 to 3, **characterized in that** the lateral protection printed circuit (CIPL) comprises at least one opening (OE1, OE2) for positioning at least one elastomer connector.

5. The hybrid transaction card reading system (SLH) according to any of claims 1 to 4, **characterized in that** the means for reading a magnetic track comprise a magnetic reading head and a reverse tilting system within which the magnetic reading head is inserted.

6. The hybrid transaction card reading system (SLH) according to claim 5, **characterized in that** the magnetic reading head comprises means for connecting to a signal transmission cable.

7. The hybrid transaction card reading system (SLH) according to claim 6, **characterized in that** the signal transmission cable comprises a multi-layer flexible printed circuit, the outer layer of the multi-layer flexible printed circuit comprising a protection mesh.

8. The hybrid transaction card reading system (SLH) according to any of claims 1 to 7, **characterized in that** the dimensions of the protection device (BNK) are shaped so as to protect access to the chip reading means.
